Europäisches Patentamt

European Patent Office

Office européen des brevets

(19)

(11) Veröffentlichungsnummer: **0 174 511**
**A1**

(12) **EUROPÄISCHE PATENTANMELDUNG**

(21) Anmeldenummer: 85110158.4

(22) Anmeldetag: 13.08.85

(51) Int. Cl.⁴: **G02B 26/02** , G01R 19/165

(30) Priorität: 29.08.84 DE 3431769
01.07.85 DE 3523488

(43) Veröffentlichungstag der Anmeldung:
**19.03.86 Patentblatt 86/12**

(84) Benannte Vertragsstaaten:
AT CH DE FR IT LI NL SE

(71) Anmelder: **Siemens Aktiengesellschaft**
**Berlin und München Wittelsbacherplatz 2**
**D-8000 München 2(DE)**

(72) Erfinder: **Gassong, Siegfried**
**Aufsessstrasse 4**
**D-8520 Erlangen(DE)**
Erfinder: **Niewisch, Joachim, Dr.**
**Straisunder Strasse 14**
**D-8500 Nürnberg(DE)**

(54) **Faseroptischer Stromsensor.**

(57) Die Erfindung bezieht sich auf einen faseroptischen Stromsensor. Erfindungsgemäß ist wenigstens eine Lichtleitfaser (48) vorgesehen, deren eines Ende (48) mit einer magnetischen Schicht (20) versehen ist und im Magnetfeld eines stromführenden Leiters (26) angeordnet ist. Mittels einer optischen vorrichtung (90) wird die Verschiebung $\alpha$ des optischen Strahlenganges des aus dem Ende (48) der Lichtleitfaser (46) austretenden Lichtes gemessen. Dadurch wird erreicht, daß man einen sehr empfindlichen, breitbandigen faseroptischen Stromsensor erhält, den man in der Nähre beispielsweise einer starkstromführenden Hochspannungsleitung anordnen kann. Außerdem kann man den Strom im Leiter 26 potentialfrei messen und die Entfernung zwischen Sensor und Auswerteelektronik nahezu beliebig wählen.

EP 0 174 511 A1

Faseroptischer Stromsensor

Die Erfindung bezieht sich auf einen faseroptischen Stromsensor für Schutzzwecke.

Es sind faseroptische Stromsensoren bekannt, die den Faraday-Effekt ausnutzen. Bei dem bekannten Faraday-Effekt wird in bestimmten lichtleitenden Materialien die Polarisationsebene eines linear polarisierten Lichtstrahls unter dem Einfluß eines Magnetfeldes, das sich entlang dem Lichtstrahl erstreckt, um eine Achse gedreht, die parallel zum Lichtstrahl verläuft. Das Ausmaß der Drehung der Polarisationsebene ist im wesentlichen proportional zur Größe des Magnetfeldes.

Es ist ein optischer Schalter für Lichtleiterkommunikationsnetze bekannt, der eine geringe Schaltenergie benötigt. Er erhält einen beweglichen und zwei feste Lichtleitfasern, eine Spule und ein Paar Permanentmagnete. Die bewegliche Lichtleitfaser ist im Bereich der Spule mit einer magnetischen Legierungsschicht versehen. Außerdem ist die Spule im Magnetfeld der Permanentmagnete angeordnet. Die bewegliche Lichtleiterfaser und eine befestigte Lichtleitfaser sind axial angeordnet. Die axiale Magnetisierung der magnetischen Legierungsschicht kann mit Hilfe der Spule umgekehrt werden. Somit kann die bewegliche Lichtleitfaser zwischen den beiden befestigten Lichtleitfasern schalten (Electronics, Februar 9, 1984, Seite 82).

Der Erfindung liegt nun die Aufgabe zugrunde, einen faseroptischen Stromsensor für Schutzzwecke anzugeben, der bei einfachem Aufbau eine ausreichende Empfindlichkeit und Potentialtrennung hat. Außerdem soll eine nahezu beliebige Entfernung zwischen Sensor und Auswerteelektronik möglich sein und die auswertbare Bandbreite dieses faseroptischen Stromsensors soll möglichst einige kHz betragen.

Diese Aufgabe wird erfindungsgemäß gelöst mit den kennzeichnenden Merkmalen des Anspruchs 1. Dadurch, daß ein Ende wenigstens einer Lichtleitfaser mit einer magnetischen Schicht versehen ist und in einem Magnetfeld eines stromführenden Leiters angeordnet ist, wirkt auf dieses Ende eine Kraft. Diese Kraft bewirkt eine Verschiebung des optischen Strahlenganges des aus diesem Ende der Lichtleitfaser austretenden Lichtes. Diese Verschiebung ist ein Maß für den durch den Leiter fließenden Strom. Durch die Verwendung wenigstens einer Lichtleitfaser und einer optischen Vorrichtung zum Messen der Verschiebung des optischen Strahlenganges ist eine Potentialtrennung für annähernd beliebige Potentialdifferenzen gegeben. Somit ist eine bevorzugte Anwendung des faseroptischen Stromsensors bei Strommessungen in Hochspannungsanlagen für Schutz zwecke vorgesehen. Durch die Faserlänge des Endes der Lichtleitfaser und durch die Magnetmasse der magnetischen Schicht wird die Bandbreite dieses faseroptischen Stromsensors bestimmt.

In einer vorteilhaften Ausführungsform des faseroptischen Stromsensors sind die Enden einer ersten und zweiten Lichtleitfaser axial einander gegenüber angeordnet und parallel zur Symmetrieachse eines stromführenden Leiters angeordnet und jeweils mit einer Permanentmagnetschicht versehen. Als Lichtquelle ist eine lichtemittierende Diode LED vorgesehen. Bei dieser Anordnung sind jeweils die an den magnetischen Enden wirksamen Kräfte und die daraus resultierenden Drehmomente bezogen auf die Haltevorrichtung gleich groß aber entgegengesetzt gerichtet. Das wirksame Magnetfeld in Bezug auf die magnetischen Enden der Lichtleitfasern ist beispielsweise homogen.

In einer weiteren vorteilhaften Ausführungsform befindet sich gegenüber dem mit einer magnetischen Schicht versehenen Ende einer Lichtleitfaseer eine reflektierende Fläche. Die Intensität des in die Lichtleitfaser zurückreflektierten Lichtes ist ein Maß für die Verschiebung des optischen Strahlenganges des aus der Lichtleitfaser austretenden Lichtes. Dadurch, daß die Aufspaltung in eine optische Sende- und Empfangsleitung erst außerhalb des Sensorelementes erfolgt, können die geometrischen Abmessungen des faseroptischen Stromsensors weiter verringert werden.

In einer besonders vorteilhaften Ausführungsform wird die reflektierende Fläche durch eine der Stirnflächen einer in der Haltevorrichtung angeordneten Lichtleitfaser gebildet. Um den Verlauf der Kennlinie, d.h. der Beziehung zwischen Auslenkung der Faser und des Verhältnisses der Intensität des gesendeten Lichtes zur Intensität des reflektierten Lichtes zu beeinflussen, können die Faserendfläche oder die reflektierende Fläche zusätzlich gekrümmt sein.

In weiterer vorteilhaften Ausführungsformen ist der Stromsensor im Innern eines teilweise zu einer uförmigen Schleife oder einer Spule geformten Stromleiters angeordnet. Dadurch wird das Magnetfeld am Ort des Sensorelementes verstärkt und homogenisiert und die Empfindlichkeit der Anordnung vergrößert.

Zur weiteren Erläuterung wird auf die Zeichnung Bezug genommen und in deren

Figur 1 eine Ausführungsform gemäß der Erfindung schematisch dargestellt ist. In den

Figuren 2 und 3 sind vorteilhafte Ausführungsformen der Erfindung veranschaulicht.

Figuren 4 und 5 zeigen weitere vorteilhafte Ausführungsformen der Erfindung. In den

Figuren 6 und 7 sind besonders empfindliche Anordnungen des faseroptischen Stromsensors gemäß der Erfindung dargestellt.

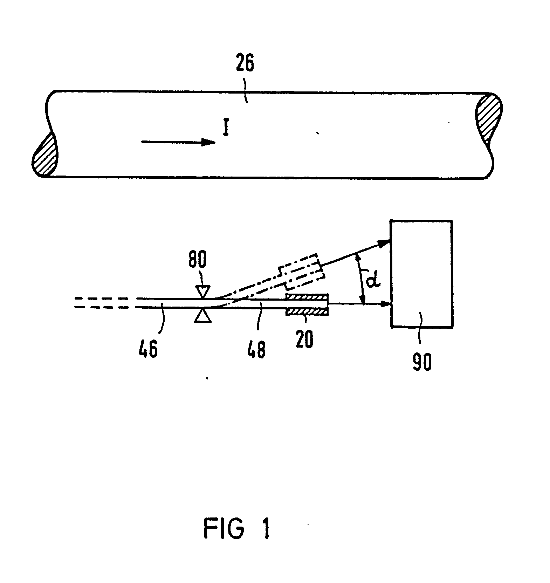

Gemäß Figur 1 ist ein Ende 48 einer Lichtleitfaser 46 mit einer magnetischen Schicht 20 versehen und im Magnetfeld eines stromführenden Leiters 26 angeordnet. Durch die vom Magnetfeld auf die magnetische Schicht 20 ausgeübte Kraft wird das freie Ende 48 der in einer Haltevorrichtung 80 eingespannten Lichtleitfaser 46 aus der dem stromlosen Fall entsprechenden Ruhelage ausgelenkt. Die Verschiebung α des optischen Strahlenganges des aus der Lichtleitfaser 46 austretenden Lichtes wird mittels einer optischen Vorrichtung 30 gemessen und ist ein Maß für den Strom I, der durch den Leiter 26 fließt.

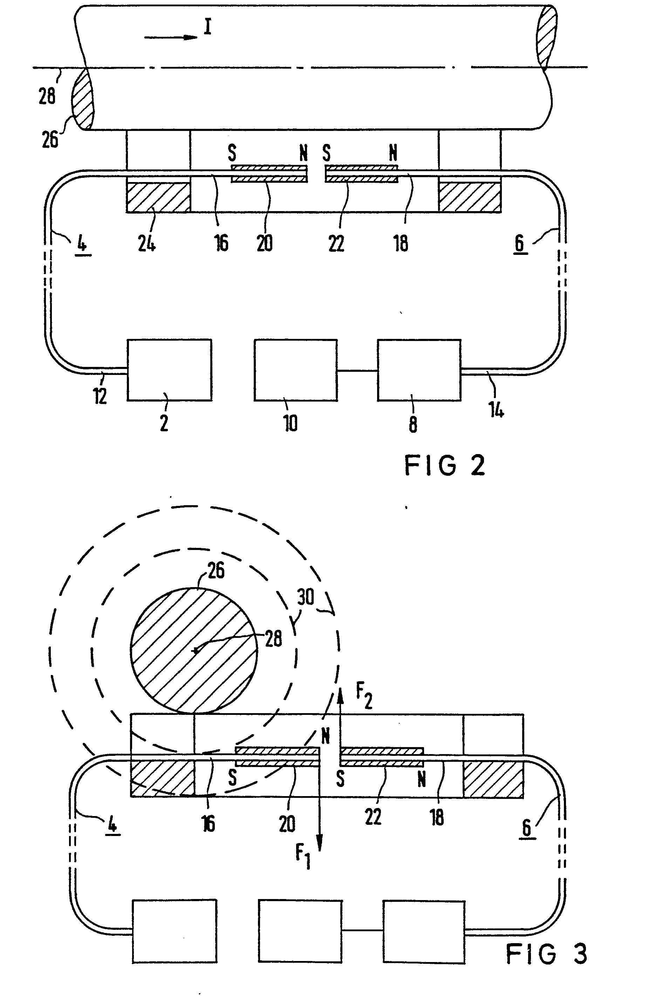

In der Ausführungsform nach Figur 2 enthält ein faseroptischer Stromsensor eine Lichtquelle 2, zwei Lichtleitfasern 4 und 6, einen Fotoempfänger 8 und eine Auswerteelektronik 10. Das eine Ende 12 der ersten Lichtleitfaser 4 ist mit der Lichtquelle 2 und das eine Ende 14 der zweiten Lichtleitfaser 6 ist mit dem Fotoempfänger 8, der beispielsweise eine Fotodiode ist, verbunden. Die beiden anderen Enden 16 und 18 sind jeweils mit einer magnetischen Schicht, vorzugsweise einer Permanentmagnetschicht 20 bzw. 22 versehen. Die mit den Permanentmagnetschichten 20 und 22 versehenen Enden 16 und 18 sind mit einer Haltevorrichtung 24 jeweils beispielsweise in unmittelbarer Nähe eines stromführenden Leiters 26 angeordnet. Die Permanentmagnetschichten 20 und 22 sind jeweils an den Enden 16 und 18 axial polarisiert. Die Enden 16 und 18 werden axial einander gegenüber und parallel zur Symmetrieachse 28 des Leiters 26 derart angeordnet, daß beispielsweise bei einem stromlosen Leiter 26 eine maximale Transmission des Lichtes der Lichtquelle 2 erreicht wird. Als Lichtquelle 2 ist beispielsweise eine Glühlampe, vorzugsweise ein Laser, insbesondere eine lichtemittierende Diode LED, vorgesehen. Wenn ein Strom I durch den Leiter 26 fließt, wirkt jeweils eine Kraft auf die Enden 16 und 18 der Lichtleitfasern 4 und 6 infolge des entstandenen Magnetfeldes. Dieses Magnetfeld ist in Bezug auf die Enden 16 und 18 homogen, d.h. die Kräfte bzw. die daraus resultierenden Drehmomente sind dem Betrag gleich groß. Durch die einwirkenden Kräfte werden die Enden 16 und 18 gegenüber ihrer Ruhelage gegeneinander versetzt, d.h. die Bewegungsrichtung am Ende 16 ist aus der Zeichenebene herausgerichtet und die Bewegungsrichtung am Ende 18 ist in die Zeichenebene hineingerichtet. Dadurch wird die Transmission des Lichtes, das vom Fotoempfänger 8 empfangen wird, geschwächt. In der anschließenden Auswerteelektronik 10, die beispielsweise ein Mikrocomputer sein kann, wird jedem Transmissionswert in einem vorbestimmten Strombereich, der beispielsweise etwa das 10-fache des Nennstroms beträgt, ein Stromwert zugeordnet. Im Kurzschlußfall, wenn der Wert des durch den Leiter 26 fließenden Stromes I beispielsweise etwa gleich dem 100-fachen des Nennstromes ist, ermittelt die Auswerteelektronik 10 beispielsweise aus der Steilheit der Transmissionsänderung von 100 % auf 0 % den Stromwert des tatsächlich fließenden Stromes I.

In einer weiteren Ausführungsform nach Figur 3 sind die axial einander gegenüber angeordneten mit den Permanentmagnetschichten 20 und 22 versehenen Enden 16 und 18 der Lichtleitfasern 4 und 6 senkrecht zur Symmetrieachse 28 des Stromleiters 26 angeordnet. Das durch den stromführenden Leiter 26 entstandene Magnetfeld ist beispielsweise durch gestrichelte kreisförmige Linien 30 veranschaulicht. An den Enden 16 und 18 der Lichtleitfasern 4 und 6 wirken Kräfte $F_1$ und $F_2$, die unterschiedlich groß und entgegengesetzt sind. Die unterschiedlichen Beträge der Kräfte $F_1$ und $F_2$ sind durch unterschiedliche Längen der Pfeile in der Figur veranschaulicht. Die Wirkrichtung der Kräfte $F_1$ bzw. $F_2$ ist jeweils das Ergebnis der Überlagerung des Magnetfeldes des stromdurchflossenen Leiters 26 mit dem der Dipole an den Enden 16 bzw. 18 der Lichtleitfasern 4 bzw. 6. Das Ende 16, daß der Symmetrieachse 28 beispielsweise näher zugeordnet ist, wird infolge der größeren Kraft stärker aus seiner Ruhelage ausgelenkt, als das Ende 18. Deshalb ist es vorteilhaft, wenn man beispielsweise nur das dem Stromleiter 26 am nächsten angeordnete Ende 16 der Lichtleitfaser 4 mit einer Permanentmagnetschicht 20 versieht. Die unterschiedlichen Kräfte entstehen dadurch, daß das Magnetfeld des stromdurchflossenen Leiters 26 in Bezug auf die Enden 16 und 18 inhomogen ist.

Durch diese Gestaltung erhält man einen faseroptischen Stromsensor, den man in der Nähe eines stromführenden Leiters 26, beispielsweise einer Hochspannungsleitung, anordnen kann und der bei gleicher Bauweise für verschiedene Strombereiche eingesetzt werden kann. Außerdem kann man den Strom im Leiter 26 potentialfrei messen und die Entfernung zwischen Sensor und Auswerteelektronik 10 nahezu beliebig, beispielsweise etwa einige m, bis zu einem km, wählen. Mit diesem einfach aufgebauten Stromsensor kann man Wechselstrom und auch unter Umständen Gleichstrom messen, wobei man bei Wechselstrom an die Lichtquelle 2 keine hohen Anforderungen, beispielsweise Stabilität oder Intensität des Lichtes, stellen braucht, da im Feldnulldurchgang ein Referenzpunkt vorhanden ist. Durch diesen Referenzpunkt kann man auf einfache Weise etwaige Umwelteinflüsse auf dem Übertragungsweg, sowie Alterung der Lichtquelle und des Empfängers korrigieren.

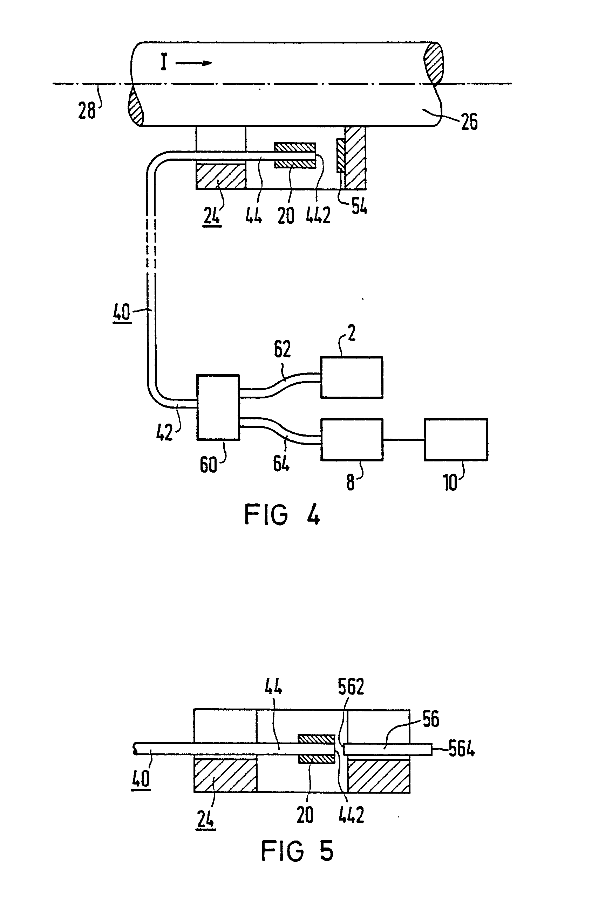

In der Ausführungsform gemäß Figur 4 enthält ein faseroptischer Stromsensor eine Lichtquelle 2, einen Fotoempfänger 8, eine Lichtleitfaser 40, eine Auswerteelektronik 10 und einen Faserkoppler 60. Die Lichtquelle 2 und der Fotoempfänger 8 sind jeweils mit Lichtleitfasern 62 bzw. 64 mit dem Faserkoppler 60 verbunden. Der Faserkoppler 60 ist mit einem Ende 42 der Lichtleitfaser 40 verbunden. Die Lichtleitfaser 40 ist am anderen Ende 44 mit einer magnetischen Schicht 20 versehen. Das Ende 44 der Lichtleitfaser 40 ist beispielsweise parallel zur Symmetrieachse 28 des Leiters 26 in einer Haltevorrichtung 24 angeordnet. Gegenüber dem Ende 44 ist eine reflektierende Fläche 54 in der Haltevorrichtung 24 beispielsweise derart angeordnet, daß bei einem stromlosen Leiter 26 das aus der Lichtleitfaser 40 am Ende 44 austretende Licht auf die reflektierende Fläche 54 auftrifft und wenigstens teilweise in die Lichtleitfaser 40 zurückreflektiert wird. Wenn ein Strom I durch den Leiter 26 fließt, wird durch die auf die magnetische Schicht 20 wirkende Kraft das Ende 44 der Lichtleitfaser 40 aus der parallelen Lage zur Symmetrieachse 28 ausgelenkt. Dadurch wird der Anteil des in die Lichtleitfaser 40 zurückreflektierten Lichtes verringert. Die Aufspaltung in eine optische Sende- und Empfangsleitung 62 bzw. 64 erfolgt erst außerhalb des Sensorelementes mit einem Faserkoppler 60. Somit muß nur eine einzige Lichtleitfaser 40 zum überwachten Stromleiter 26 geführt werden und die geometrischen Abmessungen des faseroptischen Stromsensors können gegenüber den Ausführungsformen gemäß der Figuren 2 und 3 weiter verringert werden. In diesen Ausführungsformen muß nämlich wenigstens eine der beiden Lichtleitfasern 4 oder 6 gebogen werden, um gemeinsam mit der anderen Faser 6 bzw. 4 zur Steuerelektronik geführt werden zu können. Dabei begrenzt der minimal mögliche Biegeradius der Lichtleitfaser die Miniaturisierung des Sensors.

Die magnetische Schicht 20 wird beispielsweise durch einen permanentmagnetischen Werkstoff gebildet. Für Anwendungen bei Stromleitern, die hohe Ströme führen und somit an die Empfindlichkeit der Anordnung geringere Anforderungen stellen, kann es jedoch auch von Vorteil sein, das Ende 44 der Lichtleitfaser 40 mit einem weichmagnetischen Werkstoff zu versehen. Die Verwendung eines weichmagnetischen Werkstoffes hat neben der leichteren Verarbeitbarkeit auch den Vorteil, daß die Genauigkeitsanforderungen beim mechanischen Aufbau des Sensors verringert werden können, da die Richtung der Auslenkung des Endes 44 der Faser 40 bei Verwendung einer weichmagnetischen Schicht 20 unabhängig von der Richtung des Stromes im Stromleiter 26 ist und somit bei Faserversatz die Transmission im Feldnulldurchgang bei Wechselstrom immer als Maximum oder Minimum ge geben ist. Eine Erhöhung der Empfindlichkeit der Anordnung kann erreicht werden, wenn die reflektierende Fläche 54 und/oder die Faserendfläche 442 eine geeignete Krümmung aufweist.

In der Ausführungsform nach Figur 5 ist gegenüber dem Ende 44 der Lichtleitfaser 40 eine Lichtleitfaser 56 in der Haltevorrichtung 24 angeordnet. Eine der beiden Stirnflächen 562 und 564 der Lichtleitfaser 56 ist mit einer reflektierenden Schicht versehen. Dadurch erhält man auf einfache Weise eine reflektierende Fläche, die nicht größer ist als die Fläche der Austrittsöffnung 442 der Lichtleitfaser 40 und somit eine gegenüber der Ausführungsform gemäß Figur 1 erhöhte Empfindlichkeit der gesamten Anordnung. Durch eine geeignete Krümmung wenigstens einer der Stirnflächen 562, 564 und 442 kann die Kennlinie den Erfordernissen entsprechend beeinflußt werden.

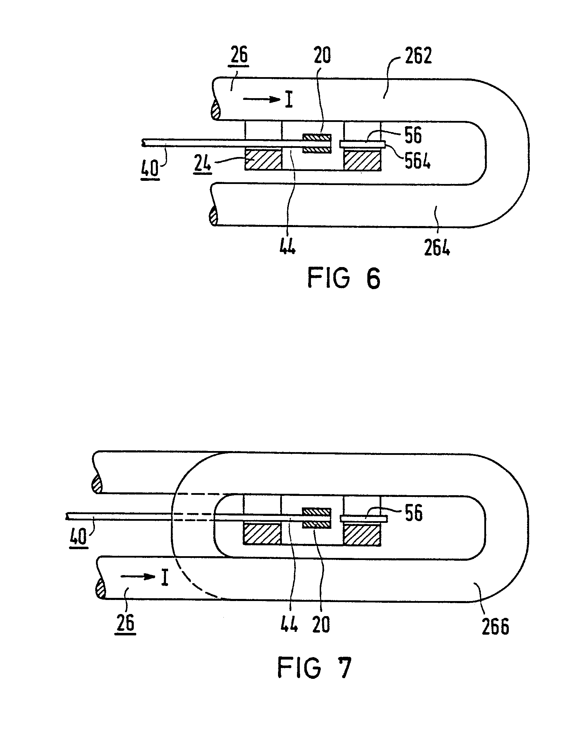

In der Ausführungsform gemäß Figur 6 hat der zu berwachende Stromleiter 26 die Gestalt einer u-förmigen Schleife. Zwischen den annähernd parallelen Schenkeln 262 und 264 des Stromleiters 26 ist der optische Stromsensor derart angeordnet, daß das Ende 44 der Lichtleitfaser 40 und die mit einer reflektierenden Stirnfläche 564 versehene Lichtleitfaser 56 ebenfalls annähernd parallel zu den Schenkeln 262 und 264 verlaufen. Dadurch wird die am Ort der magnetischen Schicht 20 herrschende magnetische Feldstärke erhöht und der räumliche Gradient des Magnetfeldes gegenüber einer Anordnung mit einem geradlinigen Stromleiter verringert.

Die Empfindlichkeit der Anordnung kann noch erhöht werden, wenn ein Teil des Stromleiters 26 in der Ausführungsform gemäß Figur 7 zu einer Spule 266 aufgewickelt wird und der optische Stromsensor im Innern dieser Spule 266 derart angeordnet ist, daß das Ende 44 der Faser 40 annähernd senkrecht zu den magnetischen Feldlinien im Innern der Spule 266 verläuft.

**Ansprüche**

1. Faseroptischer Stromsensor, **dadurch gekennzeichnet,** daß wenigstens eine Lichtleitfaser (46) vorgesehen ist, deren eines Ende (48) mit einer magnetischen Schicht (20) versehen ist und im Magnetfeld eines stromführenden Leiters (26) angeordnet ist und daß eine optische Vorrichtung (90) zum Messen der Verschiebung (α) des optischen Strahlenganges des aus diesem Ende (48) der Lichtleitfaser (46) austretenden Lichtes vorgesehen ist.

2. Faseroptischer Stromsensor nach Anspruch 1, **dadurch gekennzeichnet,** daß zwei Lichtleitfasern (4, 6) vorgesehen sind, daß eine erste Lichtleitfaser (4) an einem Ende (12) mit einer Lichtquelle (2) und eine zweite Lichtleitfaser (6) an einem Ende (14) mit einem Fotoempfänger (8) mit nachgeschalteter Auswerteelektronik (10) versehen ist und daß wenigstens eine der beiden anderen Enden (16 bzw. 18) mit einer Permanentmagnetschicht (20 bzw. 22) versehen sind und diese Enden (16, 18) axial einander gegenüber im Magnetfeld eines stromführenden Leiters (26) angeordnet und mit einer Haltevorrichtung (24) versehen sind.

3. Faseroptischer Stromsensor nach Anspruch 2, **dadurch gekennzeichnet,** daß die mit den Permanentmagnetschichten (20, 22) versehenen Enden (16, 18) parallel zur Symmetrieachse (28) des stromführenden Leiters (26) angeordnet sind.

4. Faseroptischer Stromsensor nach Anspruch 2, **dadurch gekennzeichnet,** daß die mit den Permanentmagnetschichten (20, 22) versehenen Enden (16, 18) senkrecht zur Symmetrieachse (28) des stromführenden Leiters (26) angeordnet sind.

5. Faseroptischer Stromsensor nach Anspruch 1, **dadurch gekennzeichnet,** daß eine Lichtleitfaser (40) vorgesehen ist, die an einem Ende (42) mit einem Faserkoppler (60) verbunden ist, der durch Lichtleitfasern (62 und 64) mit einer Lichtquelle (2) und einem Fotoempfänger (8) mit nachgeschalteter Auswerteelektronik (10) verbunden ist und daß das andere Ende (44) mit einer magnetischen Schicht (20) versehen und im Magnetfeld eines stromführenden Leiters (26) mittels einer Haltevorrichtung (24) angeordnet ist und daß sich gegenüber diesem Ende (44) eine reflektierende Fläche (54) befindet.

6. Faseroptischer Stromsensor nach Anspruch 5, **dadurch gekennzeichnet,** daß die reflektierende Fläche durch eine der Stirnflächen (562 bzw. 564) einer in der Haltevorrichtung (24) angeordneten zweiten Lichtleitfaser (56) gebildet wird.

7. Faseroptischer Stromsensor nach Anspruch 5, **dadurch gekennzeichnet,** daß die Stirnfläche (442) des Endes (44) der Lichtleitfaser (40) und/oder die reflektierende Fläche (54) gekrümmt ist.

8. Faseroptischer Stromsensor nach Anspruch 6, **dadurch gekennzeichnet,** daß die Stirnfläche (442) des Endes (44) der Lichtleitfaser (40) und/oder eine der Stirnflächen (562 bzw. 564) der zweiten Lichtleitfaser (56) gekrümmt ist.

9. Faseroptischer Stromsensor nach einem der Ansprüche 5 bis 8, **dadurch gekennzeichnet,** daß ein Teil des Stromleiters (26) eine u-förmige Schleife mit wenigstens annähernd parallelen Schenkeln (262 und 264) aufweist und daß das Ende (44) der Lichtleitfaser (40) parallel zu den Schenkeln (262 und 264) der u-förmigen Schleife angeordnet ist.

10. Faseroptischer Stromsensor nach einem der Ansprüche 5 bis 8, **dadurch gekennzeichnet,** daß ein Teil des Stromleiters (26) eine Spule (266) ist und daß das Ende (44) der Lichtleitfaser (40) senkrecht zum Magnetfeld im Innern der Spule (266) angeordnet ist.

11. Faseroptischer Stromsensor nach Anspruch 2 oder 5, **dadurch gekennzeichnet,** daß als Auswerteelektronik (10) ein Mikrocomputer vorgesehen ist.

FIG 1

FIG 2

FIG 3

FIG 4

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-B-2 531 398 (SIEMENS AG) <br> * Ansprüche 1,5,6; Figur * | 1-4 | G 02 B 26/02 <br> G 01 R 19/165 |
| A | | 6,10 | |
| | --- | | |
| Y | DE-B-1 268 735 (ALLIS-CHALMERS) <br> * Anspruch 1, Figur 1 * | 5 | |
| | --- | | |
| Y | DE-A-2 839 444 (E. MEYER ZUR CAPELLEN) <br> * Ansprüche 1,10,11 * | 5 | |
| | --- | | |
| A | DE-A-2 841 848 (SIEMENS AG) <br> * Figuren 1,2 * | 1 | |
| | --- | | **RECHERCHIERTE SACHGEBIETE (Int. Cl.4)** |
| A | DE-A-2 841 140 (SIEMENS AG) <br> * Figur 1 * | 1 | |
| | --- | | G 01 R 15/02 <br> G 01 R 19/145 |
| A | US-A-4 115 764 (H. YAMAGUCHI et al.) <br> * Abstract, Figur 1 * | 1 | G 01 R 19/165 <br> G 02 B 26/02 <br> G 02 F 1/01 <br> H 03 K 17/965 |
| | ----- | | |

Der vorliegende Recherchenbericht wurde für alle Patentansprüche erstellt.

| Recherchenort | Abschlußdatum der Recherche | Prüfer |
|---|---|---|
| BERLIN | 18-11-1985 | LEMMERICH J |